# FASCICULE DE BREVET EUROPEEN

(11) **EP 1 660 890 B1**
(45) Date de publication et mention de la délivrance du brevet: **09.03.2016**
(21) Numéro de dépôt: 04786295.8
(22) Date de dépôt: 11.08.2004
(51) Int. Cl.: G01P 15/125, G01P 15/13

(54) **ACCELEROMETRE A VIBRATIONS PARASITES REDUITES PAR FORME DES ELECTRODES AMELIOREE**
BESCHLEUNIGUNGSMESSER MIT VERRINGERTER STÖRVIBRATION AUFGRUND VERBESSERTER ELEKTRODENFORM
ACCELEROMETER WITH REDUCED EXTRANEOUS VIBRATIONS OWING TO IMPROVED ELECTRODE SHAPE

(30) Priorité: 13.08.2003 FR 0309899
(43) Date de publication de la demande: 31.05.2006
(73) Titulaire: Sercel, 44470 Carquefou (FR)
(72) Inventeur: MENARD, Jean-Paul, F-44470 Thouare sur Loire (FR); MOREAU, Maurice, F-49270 Landemont (FR)
(74) Mandataire: Goulard, Sophie
(86) Numéro de dépôt international: PCT/FR2004/002123
(87) Numéro de publication internationale: WO 2005/017537

(56) Documents cités:
- WO-A-01/50585
- US-A- 5 554 304
- US-A- 5 610 335
- US-A- 6 151 966
- US-B1- 6 318 174
- US-B1- 6 497 149
- US-B1- 6 507 138
- PARK K-Y ET AL: "Capacitive type surface-micromachined silicon accelerometer with stiffness tuning capability" SENSORS AND ACTUATORS A, ELSEVIER SEQUOIA S.A., LAUSANNE, CH, vol. 73, no. 1-2, 9 mars 1999 (1999-03-09), pages 109-116, XP004167325 ISSN: 0924-4247
- PARK K Y ET AL: "CAPACITIVE SENSING TYPE SURFACE MICROMACHINED SILICON ACCELEROMETERWITH A STIFFNESS TUNING CAPABILITY" MEMS 98. PROCEEDINGS IEEE OF THE 11TH ANNUAL INTERNATIONAL WORKSHOP ON MICRO ELECTRO MECHANICAL SYSTEMS. AN INVESTIGATION OF MICRO STRUCTURES, SENSORS, ACTUATORS, MACHINES AND SYSTEMS. HEIDELBERG, JAN. 25 - 29, 1998, IEEE WORKSHOP ON MICRO ELECTRO ME, 25 janvier 1998 (1998-01-25), pages 637-642, XP000829236 ISBN: 0-7803-4413-8

## Description

L'invention concerne les accéléromètres micro-usinés qui permettent notamment de mesurer le mouvement du sol pour les applications géophysiques (cartographie du sous-sol par méthode sismique).

L'invention concerne notamment les accéléromètres qui mettent en oeuvre un système masse-ressort, en particulier lorsque la masse forme une série de doigts qui se trouvent inter-digités avec des doigts correspondants d'une partie fixe.

Dans ce type de dispositif, chaque couple de doigts en vis à vis forme un condensateur de mesure.

On rappellera également ici que les doigts constituant les condensateurs peuvent être utilisés à la fois pour la mesure du déplacement par mesure de la variation de capacité, et à la fois pour rappeler la masse dans sa position d'origine, par application d'une force électrostatique au sein de chaque capacité ainsi formée. La force électrostatique de rappel peut être asservie sur la mesure capacitive de déplacement précédente.

L'ensemble de ces considérations bien connues est décrit dans l'art antérieur, notamment dans le brevet FR 2 769 369.

Avec ce type d'accéléromètre, l'homme du métier se voit typiquement confronté à la présence d'un bruit superposé à la mesure.

Le document US-6151966 décrit divers modes de réalisation d'accéléromètres conformes à la structure générale décrite précédemment. Le document US-6151966 divulgue plus précisément des électrodes comportant des ouvertures afin de réduire le poids des électrodes et limiter ainsi le risque de rupture sous l'effet des accélérations. La solution donnée dans ce document ne permet pas de résoudre le problème soulevé dans le cadre de la présente invention qui est celui de la sensibilité au bruit superposé à la mesure. Selon un mode de réalisation, le document US-6151966 propose une transition entre les électrodes et le corps de l'accéléromètre supportant les électrodes afin d'éviter de créer un point de rupture au niveau de cette zone de liaison. Cependant, pour le reste les électrodes présentant des ouvertures selon la caractéristique essentielle de ce document, présentent une section constante.

Le document US-5554304 décrit également différents modes de réalisation d'accéléromètres à masse mobile et partie fixe comprenant des électrodes interdigitées. Selon un mode de réalisation illustré sur la figure 10 de ce document, l'une des séries d'électrodes peut présenter une largeur variable, de sorte que la distance entre les électrodes fixes et les électrodes mobiles varie avec le mouvement des électrodes mobiles et ainsi la force électrostatique varie de manière inversement proportionnelle à la distance entre les électrodes. La solution préconisée dans ce document ne permet pas non plus d'adresser le problème soulevé dans le cadre de la présente invention qui est celui de réduire l'influence du bruit superposé à la mesure.

Le document US-6507138 décrit une autre structure d'accéléromètre à masse mobile et partie fixe adaptée pour tolérer des tensions de commande élevées. Là encore la solution préconisée dans le document ne permet pas de résoudre le problème soulevé selon l'invention qui est de réduire le bruit superposé à la mesure.

Dans le cas des accéléromètres incorporant une série d'électrodes interdigitées, il s'avère qu'une partie du bruit provient d'une vibration apparaissant de manière non souhaitée au niveau de chaque doigt. Ce bruit, qui peut avoir diverses origines, peut notamment provenir d'une sollicitation extérieure dont le spectre en fréquence couvre la fréquence de vibration des doigts.

Dans le cas particulier des accéléromètres à rappel de partie mobile, et notamment les accéléromètres à rappel asservi, cette vibration peut être en outre alimentée mécaniquement par les forces de rappel qui sont appliquées de manière répétée à la masse. Dans ce cas, cette vibration produit une modulation d'amplitude de la force de rappel. Il en résulte un bruit indésirable dans la bande d'intérêt.

La présence d'un bruit ayant l'une quelconque de ces différentes origines forme un premier problème.

Un second problème réside dans le fait que les doigts s'avèrent fragiles en flexion. Qu'ils vibrent en résonance ou qu'ils soient simplement soumis à de fortes accélérations, ces doigts sont sujets à des dommages par flexion.

Pour résoudre un ou l'ensemble de ces deux problèmes, l'invention consiste en un accéléromètre à masse mobile et partie fixe du type défini en revendication 1 annexée.

D'autres caractéristiques, buts et avantages de l'invention apparaîtront à la lecture de la description détaillée qui va suivre, faite en référence aux figures annexées sur lesquelles :
- la figure 1 représente schématiquement un mode particulier de réalisation d'un capteur d'accélération selon l'invention ;
- les figures 2a à 2c sont des tracés représentant les spectres en fréquence respectivement du bruit lié à la tension de rappel de la masse, d'une fonction de transformation de cette tension en force avec et sans résonance des doigts, et de la force résultante, avec et sans résonance des doigts là encore ;
- la figure 3 représente les spectres en fréquence d'une tension d'asservissement pulsée et d'un signal en créneaux fenêtrant cette tension ;
- la figure 4 représente des électrodes interdigitées selon une variante de l'invention ;
- la figure 5 représente des électrodes interdigitées selon une autre variante de l'invention.

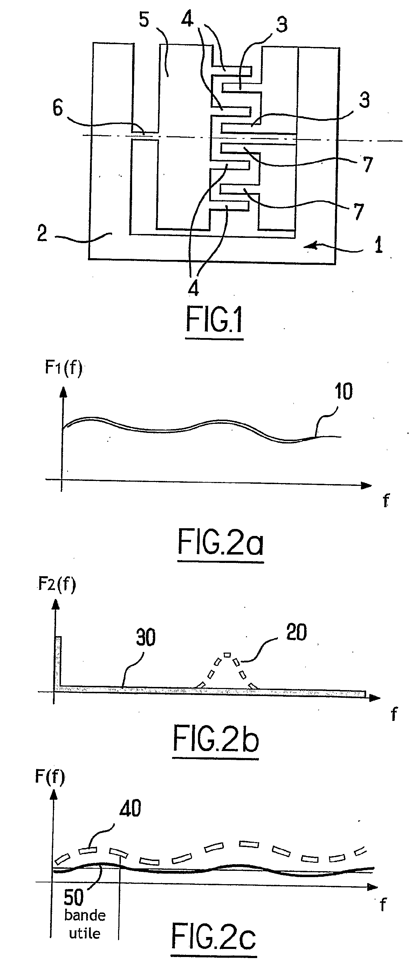

Le capteur d'accélération représenté sur la figure 1 comprend les éléments suivants, réalisés dans un même substrat semi-conducteur 1 :
- une armature fixe 2 ;
- deux séries d'électrodes fixes 3 et 7 rigidement solidaires de l'armature 2 ;
- une série d'électrodes 4 supportées par une plaque mobile 5 ;
- des ressorts 6 liant la plaque mobile 5 à l'armature 2 (un seul ressort est représenté ici, pour raison de clarté du dessin) ;

Les électrodes mobiles 4 sont électriquement isolées des électrodes fixes 3 et 7.

Les électrodes 3 forment avec les électrodes 4 en vis à vis un condensateur C1. Les électrodes 7 forment avec les électrodes 4 en vis à vis un condensateur C2.

Lorsque la masse mobile se déplace par rapport à la partie fixe, les valeurs de C1 et C2 varient en sens inverse. Ceci permet de mesurer la position relative de la masse mobile. En outre, dans le présent mode de réalisation, une tension appliquée aux bornes de C1 produit une force électrostatique qui tend à rapprocher les électrodes 3 et 4, donc à déplacer la masse mobile dans une direction, tandis qu'une tension appliquée aux bornes de C2 tend à déplacer la masse mobile dans l'autre direction.

Un circuit électronique, non représenté ici et connu de l'homme de l'art, est relié à chaque série d'électrodes fixes 3 et 7 et à la série d'électrodes mobiles 4.

Préférentiellement de type à capacités commutées, ce circuit est cadencé au rythme d'une horloge, et applique cycliquement, par phases successives, une tension de mesure aux bornes de chaque condensateur, permettant de mesurer leur capacité (mesure différentielle des deux capacités voisines). Le déplacement mesuré est indicatif du déplacement de la plaque mobile 5 due à l'accélération ponctuellement présente. La durée de la phase d'application d'une tension de mesure, notée Tc et également appelée durée de chargement, ou encore durée de la phase détecteur, est très inférieure à la période de résonance du système (et donc à la période de vibration du sol).

L'asservissement mis en place ici consiste à annuler le mouvement relatif de la masse 5 en appliquant une force entre la série d'électrodes mobiles et l'une ou l'autre des séries d'électrodes fixes (C1 ou C2). Il s'agit d'une force électrostatique et c'est la phase actionneur lorsque celle-ci est appliquée de manière temporellement distincte de la phase détecteur.

C'est préférentiellement le même circuit électronique qui alternativement mesure la position de la masse mobile et tend à la ramener à sa position initiale en appliquant les tensions adéquates aux bornes des condensateurs C1 et/ou C2.

Ainsi le circuit définit un multiplexage entre mesure et contre-réaction, avec préférentiellement une décharge des capacités entre ces deux étapes.

La gamme de fréquences pour le multiplexage est par exemple 100 à 500 fois la fréquence de résonance du système.

Dans un autre mode de réalisation, le rappel de la masse mobile peut être mis en oeuvre simultanément à la mesure de déplacement.

La puce mécanique résonne typiquement à 500 Hz. La fréquence de résonance, choisie préférentiellement au plus proche de la fréquence de vibration du sol, est, dans le présent exemple, ajustée par réglage d'une raideur électrostatique kₑ. Cette raideur est superposée à la raideur mécanique et ajustée par la durée de l'étape de chargement de mesure des capacités.

La raideur électrostatique est ici choisie pour baisser la fréquence de résonance du système, la raideur mécanique étant choisie délibérément au-delà de la fréquence haute de la bande d'intérêt.

Cette disposition optionnelle, connue du document FR 2 769 309, permet de limiter l'affalement, de réduire la distance inter-électrodes, et donc d'utiliser des champs électriques élevés (donc une forte raideur électrostatique).

Cette disposition permet en outre d'optimiser les performances dans la bande passante utile et de compenser la dispersion de raideur mécanique des ressorts de suspension de plaques mobiles, dispersion constatée typiquement avec les procédés de fabrication habituels.

Grâce à la raideur électrostatique, la fréquence apparente est ramenée à 140 Hz pour réduire au mieux le bruit dans la bande utile (0-200 Hz).

Les électrodes fixes et mobiles ont la forme de « doigts », poutres habituellement parallélépipédiques en silicium reliées entre elles par une base à la manière d'un peigne. Chacun de ces doigts présente une fréquence de résonance correspondant à celle d'une poutre encastrée à une extrémité.

Dans le cas présent, la fréquence de résonance des doigts était typiquement de 90 kHz et est passée à 585 kHz après une première modification décrite dans le texte qui suit.

Les inventeurs ont identifié que ces doigts ont une tendance à résonner considérablement, et ce avec d'autant plus d'amplitude que la pression ambiante est très faible à l'intérieur de la puce.

Le mouvement résultant est responsable du repliement en bande de base, par transposition de fréquence du bruit présent dans la force d'asservissement, et donc de la dégradation du bruit global du géophone, en particulier quand on augmente l'accélération maximale compensable (Aₘₐₓ) avec l'actionneur.

On analysera ci-après les composantes spectrales du signal de rappel respectif appliqué sur la masse.

Afin d'exposer les moyens mis en oeuvre pour limiter la résonance des doigts, on dresse d'abord ici la constatation selon laquelle la force d'asservissement répétée, F, appliquée à la plaque mobile 5, a pour expression F = (ε.S.V²)/(2.d²) avec S : surface en regard des électrodes, V : tension entre les électrodes et d : distance entre les électrodes. Si V et d varient avec le temps, on peut écrire F(t) = F1 (t).F2(t) avec F1 (t) = V(t)² et F2(t) = ε.S/2.d(t)²

Une multiplication temporelle se traduisant par une convolution fréquentielle, on a F(f) = F1(f) ⊗ F2(f).

L'allure de F1 (f) est représentée en figure 2a, par la courbe 10 (en l'absence de signal d'accélération) et celle de F2(f) en figure 2b (courbe 20 : doigts résonnants, courbe 30 doigts non résonnants). L'allure du spectre de force F(f) est également représentée en figure 2c (courbe 40 : doigts résonnants et 50 : doigts non résonnants).

On observe la remontée de bruit indésirable en bande de base due à la résonance des doigts.

En d'autres termes, les doigts entrent en résonance du fait que leur fréquence propre se trouve fort représentée dans le spectre énergétique de la force d'asservissement répétitive telle qu'adoptée dans ce type d'accéléromètre.

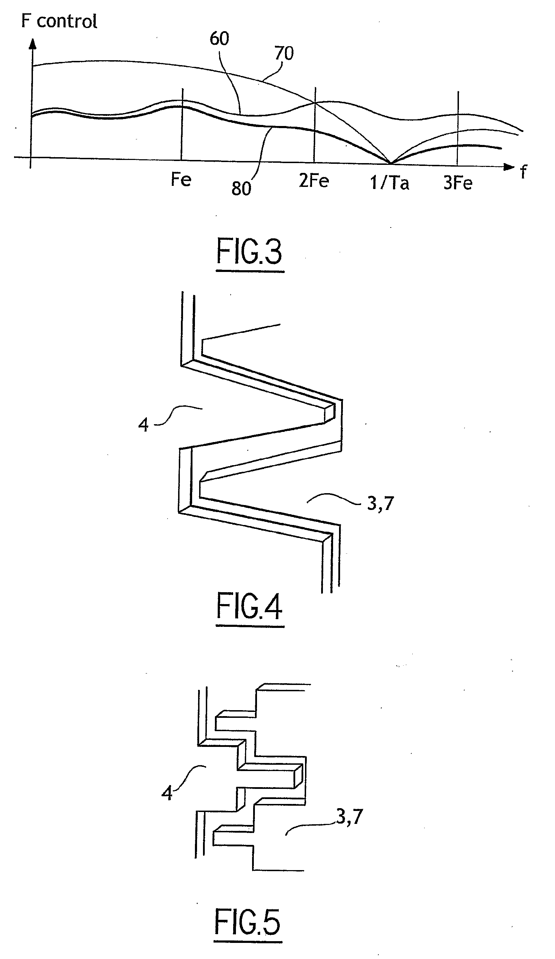

Notons que, du fait de l'échantillonnage, le spectre est répété à l'infini avec une récurrence Fe, fréquence d'échantillonnage, tel que représenté sous la référence 60 à la figure 3.

Il est intéressant d'observer que, du fait que la force de contre-réaction se présente sous la forme d'impulsions répétées de largeur Ta et non sous la forme de Diracs (largeur nulle), cela signifie que ce spectre 60 est multiplié par une fonction en sinus cardinal avec un premier zéro à la fréquence 1/Ta.

Sur la figure 3, la courbe 60 représente le spectre d'asservissement en fréquence avec des impulsions de courte durée (Dirac) et la courbe 80 avec les impulsions réelles, de durée Ta donc avec des zones assez larges à puissance presque inexistante. En ordonnée, est rapportée la valeur de la force d'asservissement F_{control} en fonction de la fréquence f.

Sur la figure 3, la courbe 70, transformée en fréquence du signal à impulsions de durée Ta, est un sinus cardinal de formule Sin (Pi.T.Fa)/(Pi.FaTa). (avec un premier zéro à la fréquence 1/Ta).

La courbe 80 est donc le résultat de la multiplication de la courbe 60 par la courbe 70.

On propose ici de profiter de ces creux d'énergie jusqu'alors non mis à profit.

Pour cela, on met en oeuvre une concordance entre l'un de ces creux d'énergie et la fréquence de résonance des doigts.

Une première disposition préférentielle est de choisir un positionnement du sinus cardinal pour placer un retour à zéro de l'énergie sur la fréquence de résonance des doigts, le spectre résultant du produit ayant alors lui aussi un retour à zéro à la résonance.

Ce positionnement est effectué par exemple en choisissant une valeur de Ta appropriée, de manière à ce que la valeur 1/Ta se trouve placée sur la fréquence de résonance des doigts. On peut, de la même manière, utiliser d'autres retours à zéro du sinus cardinal 70.

On notera que cela suppose que la fréquence des doigts soit supérieure à Fe, Ta ne pouvant être >Te (Te désigne la période d'échantillonnage).

Le choix d'un spectre ainsi placé permet un gain important sur le niveau de bruit de l'accéléromètre.

Selon une autre disposition, on configure les doigts fixes et/ou mobiles 3 et 4 pour que leur résonance se trouve ramenée dans un tel puits naturel d'énergie, puits dû à l'application des forces pendant les durées Ta en phase actionneur encadrées par des retours à zéro de la force de rappel. La fréquence préférée pour la résonance des doigts est celle égale à 1/Ta, correspondant au premier passage à zéro du sinus cardinal, transformée du signal en créneaux.

Typiquement, Ta vaut 14/32 Te, donc 1/Ta=585kHz pour Fe=256 kHz.

En version parallélépipédique, pour augmenter la fréquence de résonance des doigts dans un rapport 6,5 sans réduire la longueur dans le rapport racine carrée de (6,5), il faudrait des doigts d'une longueur de 160 µm, ce qui est incompatible avec les possibilités en tension de l'électronique (pour actionner la masse il faudrait des tensions élevées).

Pour modifier la fréquence de résonance des doigts, on adopte ici préférentiellement un profil trapézoïdal tel qu'illustré à la figure 4.

Avec des doigts ayant une longueur de 240 µm, une largeur L au niveau de l'ancrage ayant une valeur de 20 µm et une largeur I au sommet de 4 µm, on atteint typiquement une fréquence de résonance de 585 kHz.

Un autre mode de réalisation, représenté sur la figure 5, consiste à adopter une forme à réductions abruptes successives de la largeur, en direction de l'extrémité libre.

Un tel mode de réalisation présente des avantages supplémentaires dans sa facilité de réalisation avec des machines de découpage simples. En effet une telle forme de doigts ne nécessite aucune coupe oblique, ce qui facilite l'opération de découpage.

L'adoption d'une base large pour une forme effilée diminue la masse fléchissante et accroît la résistance mécanique à la base. La fréquence de résonance en flexion se trouve très nettement augmentée. De plus les amplitudes d'oscillations sont très nettement réduites. Toutefois, les surfaces en vis à vis entre doigts adjacents restent d'une étendue quasiment inchangée, n'affectant ainsi pratiquement pas les propriétés électriques des capacités en présence.

On préfère la forme trapézoïdale, car cette dernière ne présente aucune sous partie rectiligne et donc particulièrement flexible localement.

On prévoit également une variante de doigt à bords courbés, par exemple à courbure externe convexe, mais qui peut également être concave, formant une forme générale de trapèze arrondie. Une telle forme s'avère plus compacte et présente une fréquence de résonance encore plus élevée.

Bien qu'une forme de doigt à largeur diminuant en rapprochement de l'extrémité libre soit bénéfique à la résistance en flexion, il peut être avantageux d'adopter une forme différente, notamment pour décaler la fréquence de résonance vers une fréquence plus élevée.

Il est à noter que cette modification géométrique de la fréquence de résonance des doigts, ici exposée en référence à une source de vibration interne, permet également d'échapper à des sources de vibration d'autres natures.

Ainsi, dans le cas d'accéléromètres non asservis, et également des accéléromètres non multipléxés (c'est-à-dire notamment dans lesquels le rappel se fait simultanément à la mesure), la modification de la fréquence de résonance des doigts permet d'échapper à des fréquences de sollicitations d'origine externe.

Ainsi, on place les fréquences de résonance des doigts en dehors des plages de fréquences des vibrations d'origine externe, qui, sinon, seraient sollicitantes.

On notera que plus la fréquence de résonance est élevée, plus l'amplitude du mouvement est faible.

## Revendications

1. Accéléromètre à masse mobile (5) et partie fixe (2) utilisant des variations de capacitance (3, 4) pour détecter le mouvement de la masse (5) dans lequel une première série d'électrodes (4) solidaires de la masse (5) est interdigitée avec une série d'électrodes (3, 7) solidaires de la partie fixe (2), chaque électrode mobile (4) formant, avec une électrode fixe (3) adjacente, une capacitance variable en fonction de la position de la masse mobile (5), l'accéléromètre comprenant en outre un circuit électronique prévu pour détecter la variation d'au moins une capacitance entre masse mobile (5) et partie fixe (2) en tant qu'indicateur du déplacement de la masse mobile et pour générer également un effort électrostatique de rappel de la masse mobile (5) dans sa position d'origine de manière asservie sur une mesure de déplacement de la masse mobile (5), **caractérisé en ce que** une ou des électrode(s) (3, 4) de la masse mobile (5) et/ou de la partie fixe (2) présentent chacune une forme de doigt à base large et à profil s'amincissant en directeur de leur extrémité libre, que le circuit électronique est prévu pour générer un effort répétitif de rappel électrostatique et **en ce que** l'effort répétitif de rappel électrostatique est spécifiquement choisi pour que son spectre fréquentiel de puissance mécanique (10, 20) présente une zone à puissance sensiblement nulle à la fréquence de résonance mécanique des électrodes (4) de la masse mobile (5) et/ou de la partie fixe (2) de sorte que la fréquence de résonance des électrodes (3, 4) se trouve dans un puits d'énergie de la force électrostatique de rappel.

2. Accéléromètre selon la revendication 1, **caractérisé en ce que** les électrodes (3, 4) de la masse mobile (5) et/ou de la partie fixe (2) présentent au moins une portion à évolution continue de la largeur de leur section.

3. Accéléromètre selon l'une quelconque des revendications 1 ou 2, **caractérisé en ce que** les électrodes (3, 4) de la masse mobile (5) et/ou de la partie fixe (2) présentent au moins une portion dont la largeur de section présente des évolutions abruptes.

4. Accéléromètre selon l'une quelconque des revendications 1 à 3, **caractérisé en ce que** les électrodes (3, 4) de la masse mobile (5) et/ou de la partie fixe (2) présentent au moins une portion dont la largeur de section décroit en direction de l'extrémité libre de l'électrode considérée.

5. Accéléromètre selon l'une quelconque des revendications 1 à 4, **caractérisé en ce que** les électrodes (3, 4) de la masse mobile (5) et/ou de la partie fixe (2) incluent une forme trapézoïdale de largeur (L, I) décroissante en direction de leur extrémité libre.

6. Accéléromètre selon l'une quelconque des revendications 1 à 5, **caractérisé en ce que** les électrodes (3, 4) de la masse mobile (5) et/ou de la partie fixe (2) incluent une portion dont la largeur de section (L, I) varie par paliers de largeur constante, la largeur (L, I) changeant de manière abrupte entre chaque palier.

7. Accéléromètre selon l'une quelconque des revendications 1 à 6, **caractérisé en ce que** les électrodes (3, 4) de la masse mobile (5) et/ou de la partie fixe (2) incluent une portion dont la largeur est décroissante progressivement en direction de l'extrémité libre de l'électrode, en formant au moins un bord latéral arrondi.

8. Accéléromètre selon l'une quelconque des revendications 1 à 7, **caractérisé en ce que** les électrodes (3) de la partie fixe (2) présentent une forme complémentaire à l'interstice entre deux électrodes adjacentes (4) de la masse mobile (5).

9. Accéléromètre selon l'une des revendications 1 à 8, **caractérisé en ce que** les moyens d'asservissement mettent en oeuvre un rappel répété de la masse mobile dans des créneaux de temps (Ta), et **en ce que** la transformée en fréquence (20) du signal en créneaux correspondant présente un retour sensiblement à zéro au niveau de la fréquence de résonance des électrodes (3, 4) de la partie mobile (5) et/ou de la partie fixe (2).

10. Accéléromètre selon la revendication 9, **caractérisé en ce que** la durée moyenne des créneaux est prédéterminée pour que la transformée en fréquence (20) du signal en créneaux présente un passage à zéro (3, 4) au niveau de la fréquence de résonance des électrodes (4) de la partie mobile (5) et/ou de la partie fixe (2).

11. Accéléromètre selon la revendication 10, **caractérisé en ce que** la durée moyenne des créneaux (Ta) est choisie pour que sa transformée en fréquence (20) présente son premier retour à zéro (1/Ta) au niveau de la fréquence de résonance des électrodes (4) de la partie mobile (5) et/ou de la partie fixe (2).

12. Accéléromètre selon l'une quelconque des revendications 1 à 11, **caractérisé en ce que** la force de rappel électrostatique est mise en oeuvre par créneaux de temps de largeur moyenne Ta, et **en ce que** Ta est choisi selon la relation 1/Ta = F où F est la fréquence de résonance des électrodes (4) de la partie mobile (5) et/ou de la partie fixe (2).

13. Accéléromètre selon la revendication 12, **caractérisé en ce que** la transformée en fréquence du signal en créneaux présente la forme d'un sinus cardinal.

14. Accéléromètre selon l'une quelconque des revendications 1 à 13, **caractérisé en ce que** les bords des doigts d'électrodes ont une courbure entre nulle et convexe.

## Patentansprüche

1. Beschleunigungsmesser mit mobiler Masse (5) und festem Teil (2), der Kapazitanzschwankungen (3, 4) nutzt, um die Bewegung der Masse (5) zu ermitteln, wobei eine erste Reihe, mit der Masse (5) fest verbundener Elektroden (4) mit einer Reihe, mit dem festen Teil (2) fest verbundener Elektroden (3, 7) interdigitiert ist, wobei jede mobile Elektrode (4) mit einer benachbarten festen Elektrode (3) eine in Abhängigkeit von der Position der mobilen Masse (5) variable Kapazitanz bildet, wobei der Beschleunigungsmesser ferner einen Elektronikkreis umfasst, der vorgesehen ist, die Variation mindestens einer Kapazitanz zwischen mobiler Masse (5) und festem Teil (2) als Indikator für die Verlagerung der mobilen Masse zu ermitteln und ebenfalls eine elektrostatische Rückholkraft der mobilen Masse (5) in ihre Ursprungsposition in Verbindung mit einer Verlagerungsmessung der mobilen Masse (5) auszuüben, **dadurch gekennzeichnet, dass** eine Elektrode oder Elektroden (3, 4) der mobilen Masse (5) und/oder des festen Teils (2) jeweils eine Fingerform mit breiter Basis und sich verschlankendem Profil in Richtung ihres freien Endes aufweist/aufweisen, dass der Elektronikkreis vorgesehen ist, eine sich wiederholende Rückholkraft zu erzeugen und dass die sich wiederholende elektrostatische Rückholkraft speziell ausgewählt ist, damit ihr Frequenzspektrum mechanischer Leistung (10, 20) eine Zone mit einer Leistung von zirka Null in der mechanischen Resonanzfrequenz der Elektroden der mobilen Masse (5) und/oder des festen Teils (2) aufweist, so dass sich die Resonanzfrequenz der Elektroden (3, 4) in einer Energiesenke der elektrostatischen Rückholkraft befindet.

2. Beschleunigungsmesser nach Anspruch 1, **dadurch gekennzeichnet, dass** die Elektroden (3, 4) der mobilen Masse (5) und/oder des festen Teils (2) mindestens einen Abschnitt mit kontinuierlicher Entwicklung der Breite ihres Querschnitts aufweisen.

3. Beschleunigungsmesser nach einem der Ansprüche 1 oder 2, **dadurch gekennzeichnet, dass** die Elektroden (3, 4) der mobilen Masse (5) und/oder des festen Teils (2) mindestens einen Abschnitt aufweisen, dessen Querschnittbreite abrupte Entwicklungen aufweist.

4. Beschleunigungsmesser nach einem der Ansprüche 1 bis 3, **dadurch gekennzeichnet, dass** die Elektroden (3, 4) der mobilen Masse (5) und/oder des festen Teils (2) mindestens einen Abschnitt aufweisen, dessen Querschnittbreite in Richtung des freien Endes der entsprechenden Elektrode abnimmt.

5. Beschleunigungsmesser nach einem der Ansprüche 1 bis 4, **dadurch gekennzeichnet, dass** die Elektroden (3, 4) der mobilen Masse (5) und/oder des festen Teils (2) eine Trapezform mit der in Richtung ihres freien Endes abnehmenden Breite (L, I) einschließen.

6. Beschleunigungsmesser nach einem der Ansprüche 1 bis 5, **dadurch gekennzeichnet, dass** die Elektroden (3, 4) der mobilen Masse (5) und/oder des festen Teils (2) einen Abschnitt einschließen, dessen Querschnittbreite (L, I) in Stufen konstanter Breite schwankt, wobei sich die Breite (L, I) zwischen jeder Stufe abrupt ändert.

7. Beschleunigungsmesser nach einem der Ansprüche 1 bis 6, **dadurch gekennzeichnet, dass** die Elektroden (3, 4) der mobilen Masse (5) und/oder des festen Teils (2) einen Abschnitt einschließen, dessen Breite sich nach und nach in Richtung des freien Endes der Elektrode verringert, wobei mindestens ein abgerundeter seitlicher Rand gebildet ist.

8. Beschleunigungsmesser nach einem der Ansprüche 1 bis 7, **dadurch gekennzeichnet, dass** die Elektroden (3) des festen Teils (2) am Spalt zwischen zwei benachbarten Elektroden (4) der mobilen Masse (5) eine komplementäre Form aufweisen.

9. Beschleunigungsmesser nach einem der Ansprüche 1 bis 8, **dadurch gekennzeichnet, dass** die Regelungsmittel einen wiederholten Rückruf der mobilen Masse in Zeitimpulsen (Ta) umsetzen und dass die Frequenztransformierte (20) des entsprechenden Impulssignals eine Rückkehr etwa auf Null im Bereich der Resonanzfrequenz der Elektroden (3, 4) des mobilen Teils (5) und/oder des festen Teils (2) aufweisen.

10. Beschleunigungsmesser nach Anspruch 9, **dadurch gekennzeichnet**, das die mittlere Dauer der Impulse vorbestimmt ist, damit die Frequenztransformierte (20) des Impulssignals einen Übergang auf Null (3, 4) im Bereich der Resonanzfrequenz der Elektroden (4) des mobilen Teils (5) und/oder des festen Teils (2) aufweist.

11. Beschleunigungsmesser nach Anspruch 10, **dadurch gekennzeichnet, dass** die mittlere Dauer der Impulse (Ta) ausgewählt ist, damit ihre Frequenztransformierte (20) ihre erste Rückkehr auf Null (1/Ta) im Bereich der Resonanzfrequenz der Elektroden (4) des mobilen Teils (5) und/oder des festen Teils (2) aufweist.

12. Beschleunigungsmesser nach einem der Ansprüche 1 bis 11, **dadurch gekennzeichnet, dass** die elektrostatische Rückholkraft in Zeitintervallen mittlerer Breite Ta umgesetzt wird und dass Ta gemäß dem Verhältnis 1/Ta = F ausgewählt ist, wobei F die Resonanzfrequenz der Elektroden (4) des mobilen Teils (5) und/oder des festen Teils (2) ist.

13. Beschleunigungsmesser nach Anspruch 12, **dadurch gekennzeichnet, dass** die Frequenztransformierte des Impulssignals die Form eines Kardinalsinus hat.

14. Beschleunigungsmesser nach einem der Ansprüche 1 bis 13, **dadurch gekennzeichnet, dass** die Ränder der Elektrodenfinger eine Krümmung zwischen Null und konvex haben.

## Claims

1. An accelerometer with a moveable mass (5) and a stationary part (2) using variations in capacitance (3, 4) to detect the movement of the mass (5) in which a first series of electrodes (4) solidly connected to the mass (5) is interdigitated with a series of electrodes (3, 7) solidly connected to the stationary part (2), each moveable electrode (4) forming, with an adjacent stationary electrode (3), a variable capacitance as a function of the position of the moveable mass (5), the accelerometer further comprising an electronic circuit designed to detect the variation of at least one capacitance between the moveable mass (5) and the stationary part (2) in the guise of indicator of the displacement of the moveable mass and also to generate an electrostatic return force of the moveable mass (5) to its original position in a manner controlled by a displacement measurement of the moveable mass (5), **characterized in that** one or more electrode(s) (3, 4) of the moveable mass (5) and/or the stationary part (2) each have a finger shape with a wide base and a profile becoming thinner toward their free end, **in that** the electronic circuit is provided to generate a repetitive electrostatic return force, and **in that** the repetitive electrostatic return force is specifically chosen so that its mechanical power frequency spectrum (10, 20) has a zone with substantially no power at the mechanical resonance frequency of the electrodes (4) of the moveable mass (5) and/or at the stationary part (2) such that the resonance frequency of the electrodes (3, 4) is in an energy sink of the electrostatic return force.

2. The accelerometer according to claim 1, **characterized in that** the electrodes (3, 4) of the moveable mass (5) and/or the stationary part (2) have at least one portion continuously evolving in terms of the width of their section.

3. The accelerometer according to any one of claims 1 or 2, **characterized in that** the electrodes (3, 4) of the moveable mass (5) and/or the stationary part (2) have at least one portion whose section width has abrupt changes.

4. The accelerometer according to any one of claims 1 to 3, **characterized in that** the electrodes (3, 4) of the moveable mass (5) and/or the stationary part (2) have at least one portion whereof the section width decreases toward the free end of the considered electrode.

5. The accelerometer according to any one of claims 1 to 4, **characterized in that** the electrodes (3, 4) of the moveable mass (5) and/or the stationary part (2) include a trapezoidal shape with width (L, I) decreasing toward their free end.

6. The accelerometer according to any one of claims 1 to 5, **characterized in that** the electrodes (3, 4) of the moveable mass (5) and/or the stationary part (2) include a portion whose section width (L, I) varies in tiers of constant width, the width (L, I) changing abruptly between each tier.

7. The accelerometer according to any one of claims 1 to 6, **characterized in that** the electrodes (3, 4) of the moveable mass (5) and/or the stationary part (2) include a portion whose width decreases gradually toward the free end of the electrode, while forming at least one rounded lateral edge.

8. The accelerometer according to any one of claims 1 to 7, **characterized in that** the electrodes (3) of the stationary part (2) have a shape complementary to the interstice between two adjacent electrodes (4) of the moveable mass (5).

9. The accelerometer according to one of claims 1 to 8, **characterized in that** the control means implement a repeated return of the moveable mass in timeslots (Ta), and **in that** the frequency transform (20) of the signal into corresponding slots has a return substantially to zero at the resonance frequency of the electrodes (3, 4) of the moveable part (5) and/or the stationary part (2).

10. The accelerometer according to claim 9, **characterized in that** the mean duration of the slots is predetermined so that the frequency transform (20) of the signal into slots has a zero crossing (3, 4) at the resonance frequency of the electrodes (4) of the moveable part (5) and/or the stationary part (2).

11. The accelerometer according to claim 10, **characterized in that** the mean duration of the slots (Ta) is chosen so that its frequency transform (20) has its first return to zero (1/Ta) at the resonance frequency of the electrodes (4) of the moveable part (5) and/or the stationary part (2).

12. The accelerometer according to any one of claims 1 to 11, **characterized in that** the electrostatic return force is implemented by timeslots with mean width Ta, and **in that** Ta is chosen according to the relationship 1/Ta = F where F is the resonance frequency of the electrodes (4) of the moveable part (5) and/or the stationary part (2).

13. The accelerometer according to claim 12, **characterized in that** the frequency transform of the signal into slots assumes the form of a cardinal sine.

14. The accelerometer according to any one of claims 1 to 13, **characterized in that** the edges of the electric fingers have a curvature between zero and convex.
